# EUROPEAN PATENT SPECIFICATION

(11) **EP 1 388 261 B1**
(45) Date of publication and mention of the grant of the patent: **12.07.2006**
(21) Application number: 02738075.7
(22) Date of filing: 15.05.2002
(51) Int. Cl.: H04N 7/22, G02B 6/42, H05K 3/30, H01L 31/0203, H04B 10/158

(54) **DEVICE FOR ARRANGING A PHOTOELECTRIC TRANSDUCER AT AN ELECTRIC SIGNAL PROCESSING DEVICE**
VORRICHTUNG ZUM ANORDNEN EINES PHOTOELEKTRISCHEN WANDLERS AUF EINEM ELEKTRISCHEN SIGNALVERARBEITUNGSGERÄT
DISPOSITIF D'AGENCEMENT D'UN TRANSDUCTEUR PHOTOELECTRIQUE DANS UN DISPOSITIF DE TRAITEMENT DE SIGNAUX ELECTRIQUES

(30) Priority: 16.05.2001 US 291225 P
(43) Date of publication of application: 11.02.2004
(73) Proprietor: Premier Devices Germany GmbH, 90441 Nürnberg (DE)
(72) Inventor: LEICHT, Günter, 96047 Bamberg (DE); GRAUVOGEL, Ulrich, 90451 Nürnberg (DE)
(74) Representative: Schröer, Gernot H.
(86) International application number: PCT/EP2002/005351
(87) International publication number: WO 2002/093927

(56) References cited:
- EP-A- 0 437 954
- US-A- 5 361 318
- US-A- 5 673 083

## Description

The present invention relates to a device for arranging a photoelectric transducer at an electric signal processing device.

In cable television system (cable TV systems) television signals are transmitted from a cable television supplier or provider to a community of many different TV users via or through electrical coaxial cables or optical cables comprising glass fibers. In order to obtain a large bandwidth an optical transmission via optical cables or fibers is getting more and more common. But within the CATV communities themselves the already installed electrical coaxial cables in the buildings are still used. Therefore, the amplitude modulated (AM) optical television signals transmitted through the optical cables have to be converted into corresponding radio frequency (high frequency) electrical television signals by photoelectric (or: optoelectric, optoelectronic) transducers (or: converters) such as PIN photodetector diodes or other photodetectors.

The photoelectric transducer is fixedly connected to the end of a glass fiber for transmitting the optical signals to the optical input of the transducer. An electrical output of the photoelectric transducer is electrically connected to an electrical CATV amplifier for amplifying the converted electrical signals at the output of the transducer. The CATV amplifier contains active and passive electronic components arranged on a substrate such as a thick- or thin-film ceramic substrate or a printed circuit board (PCB) and a metal carrier body which the substrate is mounted onto and a protective cover or housing for protecting the substrate and the electronic components thereon. The metal carrier body is usually designed according to an international standard SOT115 and, accordingly, is of basically rectangular shape and of standardized dimensions.

The photoelectric transducer is mounted, directly or indirectly by means of a transducer carrier, onto the substrate and mechanically supported solely by the substrate. Furthermore, the electrical output of the transducer is electrically connected to the electronic circuits on the substrate. The glass fiber connected to the transducer is protected by a stiff rubber boot which is held fixedly and non-positively within an opening of the protective housing. The entire unit comprising the electrical amplifier and the mounted photoelectric transducer is also called an optical receiver module.

An optoelectronic transducer for use in a CATV optical receiver module is disclosed in US 5,627,531 A. This known optoelectronic transducer contains a photonic device such as a photodiode or a light emitting diode or laser fixed to a photonic device carrier of ceramic material and further contains a fiber carrier having a groove which an end portion of an optical single or multi mode fiber is mounted and fixed in by means of solder or adhesive. The fiber carrier is provided with a reflective surface and connected to the photonic device carrier in such a manner that the reflective surface is aligned with the optical fiber and the photonic device.

This known optoelectronic transducer can be used either for converting optical into electrical signals in the conventional cable TV application or for converting electrical into optical signals in modern interactive or bidirectional cable TV systems allowing for a signal transmission in the opposite direction from the TV user to the TV provider, the type of the encapsulated photonic device depending on the required signal direction.

EP 0 437 954 A1 discloses an optical-electronic interface module comprising a flexible folded printed circuit board (PCB) carrying ICs and an optoelectronic device being connected to a fiberoptic cable. A housing for the PCB is constituted by a base plate carrying the PCB, a frame, being glued onto the base plate, and a cover being glued to the frame. The optoelectronic device is held within a metal receptacle which is moulded, pressfitted or glued into a hole in an end wall of the frame surrounding the PCB. The fiberoptic cable and the optoelectronic device are arranged outside of the housing and three leads of the device protrude into the housing and are electrically contacted to an upright folded tab of the PCB.

US 5,361,318 A discloses an optical module for optical communication systems such as a data link and an optical LAN. In one known embodiment such a module comprises several submodules in each of which an optical operation element (laser diode, photodiode) is fixed to an optical connector fitted to a ferrule fixed to an end portion of an optical fiber by an adhesive. The optical connector and also a substrate supporting an electronic circuit portion are fixed to a ceramic package by an adhesive. A terminal of the optical operation element and the electronic circuit portion are electrically connected by wire bonding. Then, a cover is fixed to the ceramic package. In a second embodiment disclosed, an integrated module comprises at least one optical connector, at least one optical operation element, electronic circuit parts, a substrate and lead pins all embedded in a moulding resin member except for one protruding end of the optical connector to receive an optical fiber and outer leads of the pins.

A number of methods and devices are known in the art that are capable of mounting a photoelectric transducer to a substrate of a CATV amplifier.

It is known to mount the photoelectric transducer onto the substrate by soldering it to a mechanical metal clamp as a transducer carrier which in turn is soldered to the substrate.

Another particular method of mounting a photoelectric transducer to a substrate involves using an adhesive, such as one of UV-curable or thermosetting resins, for glueing the transducer to a plastic carrier and the carrier to the substrate.

Both known methods need no or only one extra part for the mounting of the transducer onto the CATV atnplifier, are cheap and comply with standard technologies and, thus, are appreciated and well-established amongst those skilled in the art.

It is an object of the invention to provide, however, an alternative for arranging a photoelectric transducer at an electric signal processing device, in particular a CATV or cable television amplifier.

The invention is set out in claims 1 and 3 and provides an optoelectric device comprising at least one photoelectric transducer for converting optical signals into electrical signals and/or electrical signals into optical signals, wherein the photoelectric transducer is connected with a light guide for transmitting optical signals to be converted or converted by the photoelectric transducer, an electric signal processing device and a device for arranging a photoelectric transducer at an electric signal processing device (or: signal processing means) comprising a transducer carrier into or onto which the photoelectric transducer is mountable (or: securable, arrangeable) or mounted (or: secured, arranged) and a carrier holder which the transducer carrier is detachably (or: releasably, removably) securable (or: attachable, mountable, connectable) or secured (or: attached, mounted, connected) to. The carrier holder is connected (or: secured, attached, mounted) or connectable (or: securable, attachable, mountable) with or to or onto the electrical signal processing device.

The photoelectric transducer is equipped and optically connected with the light guide, in particular a glass fiber.

According to the invention at least two additional parts are introduced to arrange the transducer at the signal processing means, namely the transducer carrier for carrying the transducer and the carrier holder for holding the transducer carrier.

According to claim 4 the device further comprises a top cover, preferably detachably, mounted or mountable onto the carrier holder and/or onto the substrate carrier body and/or onto the substrate, the top cover and the carrier holder together forming a protective housing for the transducer carrier with the mounted transducer and preferably also for the substrate or a part thereof.

The transducer carrier and/or the carrier holder and/or the top cover, if provided, comprise(s) a passage for the light guide with a passage wall protecting the light guide mechanically.

This allows for a flexible mounting of the transducer and, in particular, of a light guide connected with the transducer since the transducer and the light guide can be either be detachable from the transducer carrier or permanently fixed to the transducer carrier or even also the carrier holder, for instance by glue, without fixing the optical components permanently to the substrate carrier.

The transducer carrier and the received or mounted transducer form a transducer unit which is mounted on or into the carrier holder. Either this transducer unit can be detached from the carrier holder or the transducer from the transducer carrier or all three components can be separated easily. Therefore, the photoelectric transducer, either with its transducer carrier or alone, can in any case be removed from the signal processing device.

Since the transducer is held and preferably protected by the transducer carrier the risk of damaging the transducer during the disassembly of the transducer unit and the carrier holder or the carrier holder and the signal processing device is significantly reduced.

In case either the signal processing device or the photoelectric transducer have to be replaced due to malfunction or damage the unit to be replaced can be separated from the intact unit and be replaced by a new unit. Those skilled in the art will appreciate that the material cost of the photoelectric transducer alone and even more together with the optical fiber usually integrated therein and the connector of the optical fiber is usually more than the material cost of the electrical signal processing device, in particular more than 1.5 times the material cost of an entire electrical CATV amplifier. Accordingly, the design according to the invention that allows for easily removing and reusing (or recycling) of a good transducer from a bad electrical signal processing device is clearly advantageous.

Furthermore, if the complete optoelectric device comprising the electric signal processing device and the optoelectric transducer unit has to be disposed of the different parts can be easily separated for recycling purposes.

Therefore, although the measures according to the invention are somewhat a disadvantage compared to the state of the art since additional parts for the transducer carrier and carrier holder have to be manufactured and to be handled during the assembly process, this disadvantage is more than compensated by the advantages of the solution according to the invention over the prior art some of which are mentioned above and others are mentioned in the following.

Beside the advantages of reusing and recycling mentioned already another major advantage is that the photoelectric transducer can be placed or positioned in any desired position at or in the proximity of the signal processing means by shaping and arranging the transducer carrier and the carrier holder accordingly.

In addition, the photoelectric transducer equipped with the optical fiber is quite sensitive to both mechanical and thermal stress. The assembly according to the invention does reduce the risk of damaging the sensitive transducer considerably since the transducer does not have to be subjected to thermal influences during its assembly as in the prior art.

When referring to the term "photoelectric" this includes the transformation of light or optical signals into electrical current or electrical signals as well as of electrical current or signals into light or optical signals. The terms "optical" or "light" include not only the visible spectrum but also the infrared spectrum.

Preferred embodiments of the invention are claimed in the claims dependent upon claim 1.

The transducer is, in a preferred embodiment, detachably secured or securable to the transducer carrier, in particular by snapping means or clips. However, the transducer can also be non-detachably fixed to the transducer carrier, for instance by glue, since it could be detached from the signal processing device nevertheless.

The transducer carrier is secured or securable to the carrier holder preferably by snapping or clipping means.

The preferred application of the device according to the invention is for a electrical signal processing device comprising an electrical amplifier, in particular a CATV or cable television amplifier.

The light guide can, in a specific embodiment, be fixed within the transducer carrier, in particular by glue, in order to reduce pull stress applied to the light guide, in particular from the transducer. To this purpose the transducer carrier is preferably provided with a hole, preferable in the passage wall, through or into which glue can be applied to fix the light guide at this point to the transducer carrier and the carrier holder simultaneously.

The electrical signal processing device comprises in a preferred embodiment at least one circuit board or substrate carrying electronic components and a substrate carrier body onto which the substrate is mounted, usually also serving as a heat sink for the electronic components on the substrate and preferably consisting of metal or another material of good thermal conductivity.

Preferably, to save space on the substrate, and by that, increase the degree of freedom within the electrical portion of the signal processing device, the design of the photoelectric transducer, the transducer carrier and the carrier holder allows for the detector to be mounted apart from the substrate or the signal processing device at a predetermined minimal distance.

In an advantageous embodiment the carrier holder extends over the substrate allowing the mounted photoelectric transducer to be electrically connected easily to the signal processing device without using any space on the substrate.

In a preferred embodiment the carrier holder is secured or securable onto or to the substrate carrier body and is preferably mechanically supported solely by the substrate carrier and not by the substrate carrying the electronic components and/or circuits for the signal processing or the electrical connections therewith.

Whereas in the prior art the transducer is mounted directly or indirectly through a carrier onto the substrate carrying the electronic components and thus, the design of the electronic circuits of the signal processing device has to provide for some space for the transducer or its carrier on the substrate, the mounting of the transducer according to these embodiments of the invention is independent of the actual design of the signal processing device and electronic circuits and enables a higher degree of freedom within the electrical portion of the signal processing device.

Nevertheless, the carrier holder can also be connected to or supported by the substrate itself, in addition or exclusively.

For mounting the carrier holder onto the substrate carrier body or the substrate pins, preferably at the carrier holder, and corresponding holes, preferably in the substrate carrier body or substrate, can be provided.

The top cover preferably fixes or holds the carrier holder to, down or against the substrate carrier, in particular by non-positive connection and/or pin-hole-connection. In order to remove the transducer from the electrical signal processing device the connection between the top cover and the substrate carrier can be broken or destroyed, for instance by drilling of the pins, without damaging the transducer within the top cover, and thereafter the top cover can be removed (and thrown away) and the transducer with the carrier holder or the transducer carrier can be removed from the substrate carrier and be reused or recycled.

For self-alignment of at least one pair of the components to be connected, in particular the transducer carrier, the carrier holder, the top cover and the signal processing device and the photoelectric transducer, the two components of a pair are provided with adjusting aids and/or with self-aligning connection means. Thus, the device in this embodiment does not need for use of additional handling or aligning tools.

For guiding the light guide and protecting it from mechanical stress and bending the top cover and the carrier holder comprise two corresponding cut-out sections forming an opening, when mounted, for the light guide. In this opening or in each of the cut-out sections a highly elastic, soft inlay body is arranged, the or both inlay bodies forming a substantially loop- or ring-shaped bearing for the light guide within the opening. This embodiment allows for maximum bend of the glass fiber without inducing damage to glass fiber during the assembly of the transducer and the signal processing device.

In a specific embodiment, the carrier holder or transducer carrying device can be provided with a transducer platform for mounting the transducer carrier or the transducer and a side wall surrounding the transducer platform and preferably also the substrate when the carrier holder or transducer carrying device is mounted on the substrate carrier. This side wall could provide the lower part of a housing wall while the, for instance box shaped, outer wall of the top cover may constitute an upper part of the housing wall.

In an advantageous embodiment the carrier holder or transducer carrying device, in particular the platform part, extends over the substrate allowing the mounted photoelectric transducer to be electrically connected easily to the signal processing device without using any space on the substrate.

The various features and advantages of the subject invention will be better understood by reference to the detailed description which follows taken in conjunction with the accompanying drawings, of which:
FIG 1 illustrates a mounting scheme for mounting a photoelectric transducer at a CATV amplifier in an exploded perspective (or: isometric) rear view,
FIG 2 shows a sequence of mounting steps for mounting the photoelectric transducer according to FIG 1 into its transducer carrier in a side view,
FIG 3 illustrates the transducer carrier with the mounted transducer after carrying out the mounting steps of FIG 2 in a perspective rear view,
FIG 4 illustrates the complete mounting scheme of FIG 1 after performance of the mounting steps of FIG 2 in an exploded rear view,
FIG 5 shows the transducer unit according to FIG 3 mounted onto the carrier in a perspective front view without the sidewall of the carrier holder,
FIG 6 illustrates a mounting scheme or assembly starting from FIG 4 after mounting of the transducer unit according to FIG 2 to 4 into the carrier holder and the carrier holder onto the CATV amplifier without the top cover in a perspective rear view,
FIG 7 shows the complete assembly resulting from that of FIG 5 and 6 by mounting the top cover and
FIG 8 shows a side view of the top cover and the carrier holder with the elastic bearing for the glass fiber in greater detail.

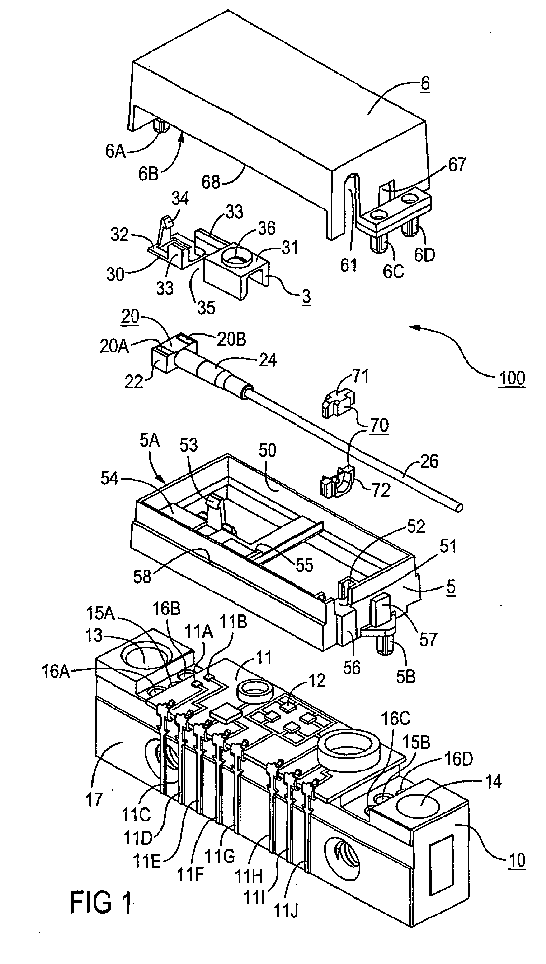

Like parts are designated by like reference symbols in FIG 1 through 8. It is worthy to note that any reference herein to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

A conventional photoelectric transducer (or: photo detector) is designated by the reference numeral 20 and includes a ceramic body containing a photodiode (or: photo detector diode) 22, in particular a PIN photo diode, a ferrule (or: holding sleeve) 24 and an end of a glass fiber (or any other light guide) 26 for transmitting optical or light signals to the photo diode 22 which converts these signals into electrical signals. The ceramic body or housing with the enclosed photodiode 22 extends orthogonal to the ferrule 24 and glass fiber 26 so that a T- or hammer shaped structure of the photoelectric transducer 20 is obtained. On the top of the ceramic body with the photodiode 22 two electrical contacts 22A and 22B are arranged at a distance to each other which the photo voltage or current of the photodiode 22 can be detected at.

As a specific signal processing device a conventional cable television amplifier or CATV amplifier is shown and designated by the reference numeral 10 and comprises a, usually flat and often rectangular, substrate 11 and a substrate carrier body 17 carrying the substrate 11 and having dimensions according to the SOT115 international standard.

Electronic or electric signal processing and/or amplifying circuits 12 are arranged on the substrate 11, which can be formed as or by a printed circuit board or other printed substrate in thick or thin film technology. The amplifying circuits usually comprise differential cascode stage amplifier(s) equipped with Si or GaAs semiconducting devices, and/or integrated circuits. Also, electrical conductors are provided on the substrate 11 connecting the electronic circuits 12 with two electrical contacts 11A and 11B on the substrate 12 for connection to the corresponding contacts 20A and 20B of the photoelectric transducer 20 and several other electrical contacts 11C through 11K leading down at one side of the substrate carrier body 17 for signal input, signal output, battery (power supply) and ground connection.

The substrate carrier body 17 usually consists of metal or another material with good thermal conductivity in order to conduct heat generated by the operating electronic components or circuits 12 away from the substrate 11 and thus serves not only as a support but also as a heat sink or cooling body for the substrate 11. The - SOT115 shaped - substrate carrier body 17 has a symmetrical shape with two higher end portions each having a screw hole 13 and 14 for screw connection to an amplifier housing (not shown) and a central portion which the substrate 11 is mounted onto. Between the end portions and the central portion two intermediate areas are formed each containing an inner connection hole 15A and 15B and two outer connection holes 16A and 16B and 16C and 16D respectively. The distance of the two screw holes 13 and 14 is determined by the SOT115 standard.

In FIG 1 all parts of a preferred embodiment of a device for arranging the photoelectric transducer 20 at the signal processing device, i.e. the substrate 11 or the circuits 12 of the amplifier 10, are shown in a yet unassembled state. The device comprises a transducer carrier 3 for carrying and holding the photoelectric transducer 20, a carrier holder 5 (or: frame cover, lower housing part) for carrying and securing the transducer carrier 3, a top cover (or: top housing part) 6 and an elastic bearing 70 for the glass fiber 26 consisting of an upper bearing part 71 and a lower bearing part 72.

The transducer carrier 3 has a front area 30 for receiving the ceramic body with the photodiode 22 and a rear area 31 for enclosing and protecting the glass fiber 26. The front area 30 of the transducer carrier 3 has a bottom section 32 which the ceramic body with the photodiode 22 is laid upon, two side sections (or: side walls) 33 as holding and/or adjusting aids which the ferrule 24 is led through and laterally limited by, a hook-shaped snapping element 34 at the front for snapping in and holding firmly the ceramic body with the photodiode 22 and an opening 35 for inserting the transducer 20 into the transducer carrier 3. The rear area 31 of the transducer carrier 3 has a passage for the glass fiber 26 having a wall which is closed but at the bottom and provided with two openings for the glass fiber 26 and, furthermore, with a glue hole 36 at the top for optional glueing and, thus, permanently fixing the introduced glass fiber 26 into the transducer carrier 3 and preferably also to the carrier holder 5 when mounted.

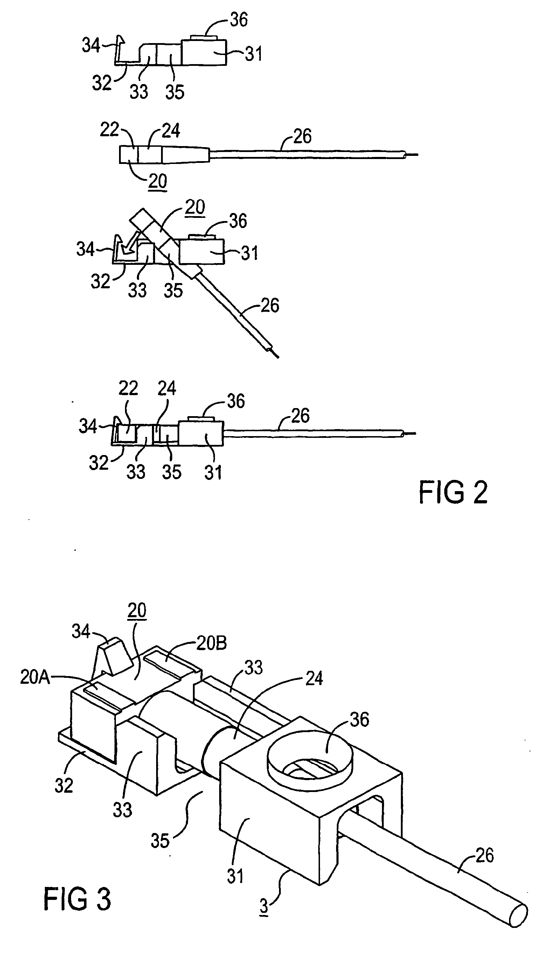

For mounting of the photoelectric transducer 20 into the transducer carrier 3 the photoelectric transducer 20 is introduced from below into the opening 35 of the bottom section 32 as can be seen in FIG 2 with the ceramic body containing the photodiode 22 first and the optical axis oriented orthogonal to the bottom section 32. Then, the photoelectric transducer 20 is rotated with the ceramic body and the photodiode 22 at its head towards the bottom section 32. The snapping element 34 is bent or deformed backwards and, subsequently, after the transducer 20 has passed it, snaps back by the elastic spring forces into a position resting, usually with a certain remaining spring pressure, on the ceramic body with the photodiode 22. At the same time, with this rotary movement the optical glass fiber 26 is introduced from below into its passage in the rear area 31 of the transducer carrier 3.

The snapping element 34 also serves as a stop lug for stopping the ceramic body with the photodiode 22 and therefore the whole transducer 20 from moving to the front or upwardly. The front portions of the side sections 33 of the transducer carrier 3 serve as stops preventing a backward movement of the ceramic body with the photodiode 22 and thus the transducer 20. Together the snapping element 34 and the side section 33 form containment or holding sections for keeping the transducer 20 from falling out in any direction. The photoelectric transducer 20 is thus held firmly in the transducer carrier 3 and can be removed at any time by performing the steps shown in FIG 2 backwards.

FIG 3 shows the transducer unit resulting from the assembly according to FIG 2 with the transducer 3 mounted in the transducer carrier 3 in an isometric front view.

Returning to FIG 1, the carrier holder (or: frame cover) 5 is shaped as a rectangular frame, has a closed side wall 50 and a transducer platform 54 for the transducer carrier 3 at the bottom and next to the side wall 50 and is open, i.e. without a cover or roof, at the top. At the inner side of the transducer platform 54 apart from the side wall 50 a hook-shaped snapping element 53 is arranged extending upright from the bottom to the top of the carrier holder 5. At one end of the transducer platform 54 a crosspiece or bar 55 is extending in a perpendicular direction from the side wall 50. at the same long side of the side wall 50 as the transducer platform 54.

Axially disposed or parallel to this long side or the side wall 50 a cut-out section or opening (or: passage) 51 is formed in the shorter side of the side wall 50 orthogonal to the longer side. At the inner side behind this opening 51 a receiving portion 52 is formed within the carrier holder 5 by two vertical grooves and a bottom section for receiving the lower bearing part 72. Below the opening 51 a first adjusting aid 56 is formed protruding from the side wall 50 outwardly and vertically and a second adjusting aid 57 similar to the first one is formed at the same short side about in the middle.

At the two shorter sides of the side wall 50 two pins 5A and 5B (only 5B visible in FIG 1) are formed extending downwards parallel to the side wall 50 and jutting out from the rest of the carrier holder 5. These two pins 5A and 5B are formed in diameter and spaced apart in such a manner that they can be inserted simultaneously into the corresponding inner holes 15A and 15B in the substrate carrier body 17 in order to mount the carrier holder 5 onto the substrate carrier body 17 and, thus, onto amplifier 10.

The top cover 6 is shaped basically as a rectangular box to be arranged onto and/or around the carrier holder 5, thus forming a closed housing for protection of the transducer 3 wherein the top cover 6 forms the upper part and the carrier holder 5 the lower part of the housing. A longer side of the top cover 6 has a recessed edge 38 which is to be rested on a corresponding base 58 at the outside of the side wall 50 at the longer side of the carrier holder 5. For adjusting the relative position of the top cover 6 and the carrier holder 5 the top cover 6 has a longer opening 61 for receiving and guiding the first adjusting aid 56 of the carrier holder 5 and a shorter opening 67 for receiving and guiding the second adjusting aid 57. At the closed ceiling or top wall of the top cover 6 a receiving portion (not visible) similar to the receiving portion 52 in the carrier holder 5 is formed within the top cover 6 for receiving the upper bearing part 71.

At the shorter side walls of the top cover 6 two pins 6A and 6B and 6C and 6D are arranged respectively all extending downwardly and meant to be inserted into the outer connection holes 16A through 16D of the substrate carrier body 17 respectively for connecting the top cover 6 with or to the substrate carrier body 17.

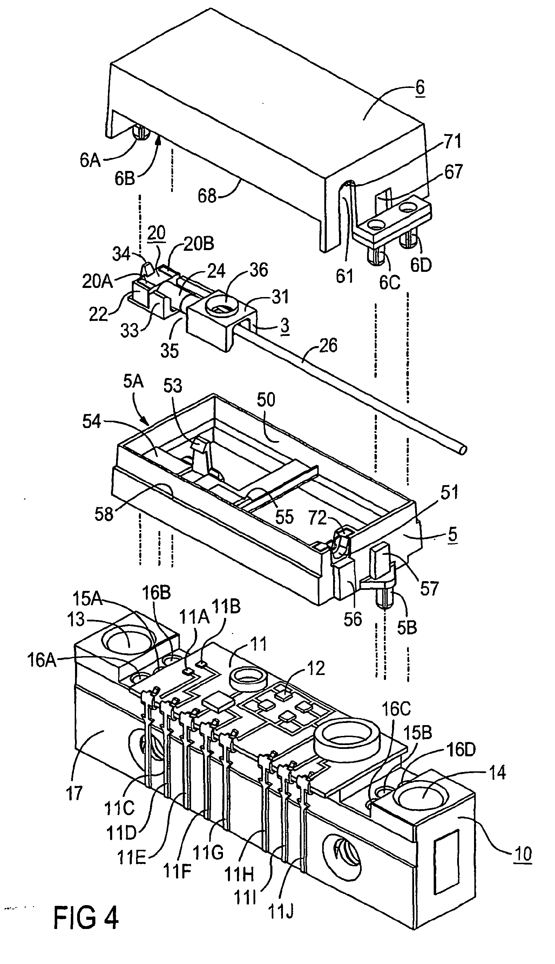

In FIG 4 the assembled transducer unit is shown in a rear view. Furthermore, in FIG 4 compared to the initial state shown in FIG 1, the lower bearing part 71 is already mounted into its corresponding receiving portion 51 in the carrier holder 5 and the other bearing part 72 is mounted into its corresponding receiving portion (not visible) in the top cover 6 behind the opening 61.

The photoelectric transducer 20 mounted in its transducer carrier 3 may now be removably mounted into or onto transducer platform 54 of the carrier holder 5 with the use of the snapping element 53 and the bar 55 serving as holding aids. To this purpose the snapping element 53 is bent backwards allowing the transducer carrier 3 to be snapped in and afterwards snaps back and rests on one of the side walls 33 with a certain remaining spring force. The transducer carrier 3 is thus fixed between the side wall 50 and the snapping element 54 laterally and between the side wall 50 and the bar 55 longitudinally or axially.

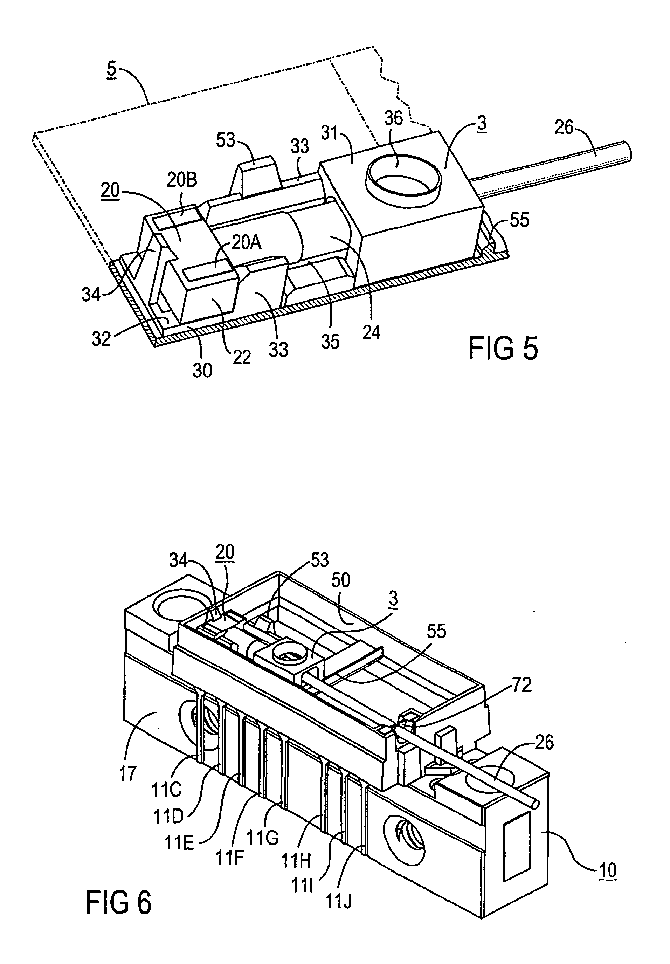

FIG 5 and 6 show the transducer carrier 3 held in such a manner in the carrier holder 5.

The holding aids (50, 53 and 55) of the transducer platform 54 and (33,34) of the transducer carrier 3 allow the transducer 20 to be held and fixed with or without the use of a glue. If glue is not used, subsequent cure processes can be avoided, if a glue is used however, applied through glue hole 36, no additional tools are required for transducer alignment, i.e., to hold the transducer 20 in its position during the cure processes time interval.

Eventually, as shown in FIG 6, the carrier holder 5 with the mounted transducer carrier 3 is mounted onto the substrate carrier body 17 by inserting its pins 5A and 5B into the corresponding connection holes (or: blind holes) 15A and 15B and resting the carrier holder 5 with its rim portion on the upper surface of the substrate carrier body 17. The pins 5A and 5B have a slightly smaller diameter than the corresponding connection holes 15A and 15B so that they just fit into the corresponding holes 15A and 15B and, thus, properly align the carrier holder 5 to the heat sink or substrate carrier body 17 and substrate 11. Therefore, the carrier holder 5 may be easily taken or lifted off the substrate carrier body 17 if, for example, the amplifier 10 is defective and must be removed. The carrier holder 5 with the most valuable photoelectric transducer 20 is, in this case, pulled apart from the substrate carrier body 17 and may be reused in another good amplifier.

As shown in FIG 6, the photoelectric transducer 20 is now held at a distance determined by the carrier holder 5 above the substrate 12 and in particular above the electrical contacts 11A and 11B so that these contacts 11A and 11B can be easily connected to the contacts 22A and 22B of the photodiode 22. The glass fiber 26 of the photoelectric transducer 20 is held in the lower bearing part 72 and guided through the opening 51 in the carrier holder 5.

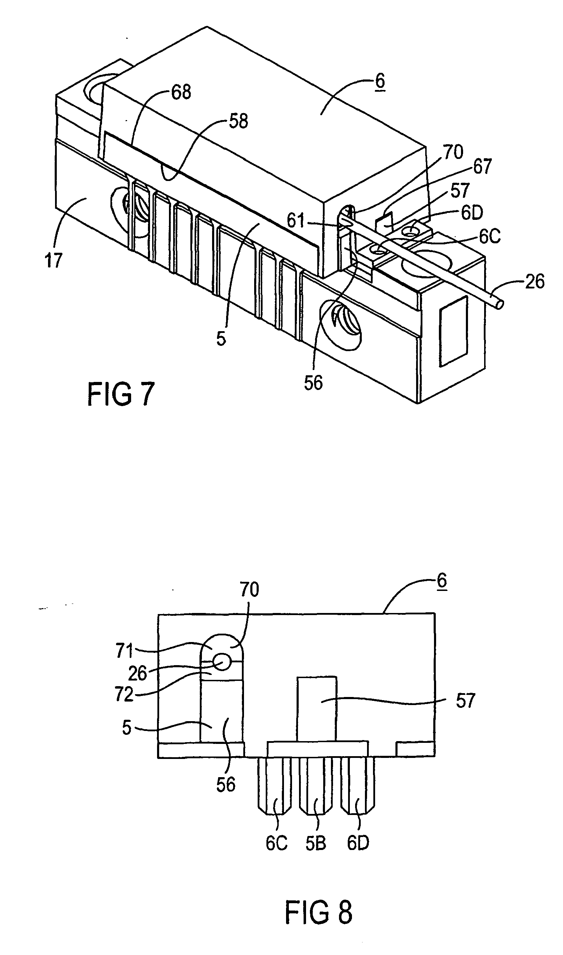

With reference to FIG 7 there is shown the completed mounting device assembly 100 with the top cover 6 mounted on top of the carrier holder 5 or frame cover. The carrier holder 5 incorporates the photoelectric transducer 20 assembled in the transducer carrier 3 (both not visible in FIG 7) which is snapped onto the transducer platform 54 (not visible in FIG 7) of the carrier holder 5, and the complete assembly is mounted to the substrate carrier body 17 and thus at the amplifier 10, in particular the amplifying circuits 12 on the substrate 11 in accordance with the present invention.

In FIG 8 this assembly according to FIG 7 is shown in a side view

The top cover 6 according to FIG 7 and 8 is mounted onto and partly over the carrier holder 5. Top cover 6 fixes the carrier holder 5 tightly to the substrate carrier body 17 and holds or pins it down by means of the four pins 16A through 16D, which, contrary to the two pins 5A and 5B of carrier holder 5, are pressed tightly or non-positively into their corresponding blind holes 16A through 16D in the substrate carrier body 17.

In another embodiment the pins 5A and 5B of the carrier holder 5 can also be larger in diameter and be pressed into the blind or connection holes 15A and 15B of the substrate carrier body 17 for the purpose to "fix" the carrier holder 5.

The pins 5A, 5B and 6A through 6D are preferably hollow in order to obtain a spring force or sufficient deformation, especially for a non-positive connection with the corresponding blind hole.

In order to loosen one of the non-positive pin-hole connections it is convenient to destroy the pins 5A and 5B and/or 6A to 6D by use of a drilling tool or the like and then withdraw the whole part, i.e. the carrier holder 5 or top cover 6.

Thus, the assembly of FIG 7 can be disassembled in the reverse order very easily by drilling open the pins 6A through 6D, removing the top cover 6 and arriving at the state shown in FIG 6 again and so forth. The apparatus or device according to FIG 1 to 7 provides the capability to remove or recycle the transducer 20 easily from the amplifier 10 with minimum risk for the transducer 20 and/or the glass fiber 26 to be damaged during this process. This is particularly advantageous since the transducer 20 and the glass fiber 26 are typically significantly more expensive than the remainder of the amplifier 10 (by approximately a factor of two to three). Accordingly, if the amplifier portion 10 of the optical receiver module is discovered to be defective, the transducer 20 together with the frame cover or carrier holder 5 can be removed from the defective amplifier 10 and can be easily reused in another amplifier.

The mounted top cover 6 according to FIG 7 provides mechanical protection for the amplifier 10 and the circuits 12 on the substrate 11.

In the embodiment shown in FIG 7 and 8 the cut-out portions or "pockets" or openings 51 and 61 in the carrier holder 5 and the top cover 6 collectively form a closed opening or passage for the glass fiber 26, i.e. a fiber exit gate.

Within this opening or fiber exit gate the two elastic bearing parts 71 and 72 collectively form a soft or flexible ring-shaped or closed bearing 70 for the glass fiber 26. The two elastic bearing parts 71 and 72 can be shaped as complementing semi-rings together forming an opening for the glass fiber 26, as shown in FIG 8, or one of the two bearing parts, in particular the lower bearing part 72, can receive the optical fiber 26 and the other bearing part 71 supports or supplements the first bearing part 72. The length of the contacting area or surface between the bearing 70 and the glass fiber 26 measured along the optical axis of the glass fiber 26 is in particular smaller than the diameter of the glass fiber 26, preferably by a factor of at least 2.

The closed elastic ring of the bearing 70 guides the glass fiber 26 and is the center of rotation for the glass fiber if bend stress is applied to it from outside the top cover 6 while the bending continues inside the top cover 6. Thus the two halves or bearing parts 71 and 72 of the rubber bearing 70 at the fiber exit gate operate together so as to provide a flexible fixation of the fiber such that if the glass fiber is bent away, for instance from the substrate carrier body 17, a center of rotation effect at the fiber exit gate is provided.

This flexible bearing 70 provides maximum tolerance to glass fiber bend during assembly of the optoelectric hybrid device. In other words, the elasticity or softness of the bearing 70 is so high that the glass fiber 26 is rotating around within and in the proximity of the bearing 70 if any bend stress is applied onto the glass fiber 26 outside of the top cover 6. Thus, the fiber is not fixed tightly by the bearing 70 but aligned in a center of rotation only. Accordingly, every bend of the glass fiber 26 outside the cover 5 and 6 allows the fiber 26 to move inside the cover 5 and 6 in a way, that the bend radius is minimized in any case, thus providing a significant risk reduction to damage the glass fiber 26 e.g. during the assembly of the optical receiver module.

Ideally a very soft material may be chosen as elastic material for the bearing 70, in particular a rubber or other elastomer with a module of elasticity typically between 1 and 10 N/mm² and/or a Share A value of typically 20, thereby allowing for a low force to be applied to the glass fiber 26 by the two rubber halves or rubber guides of the bearing parts 71 and 72.

The transducer carrier 3, the carrier holder 5 and/or the top cover 6 in all embodiments can be formed by integral plastic parts, in particular injection-moulded parts, allowing for a cheap production and great flexibility in shape and function.

The design according to the invention, in particular in the embodiments shown in FIG 1 to 8, provides the capability to align the transducer 20 precisely with respect to the substrate 11 without the need for use of additional handling tools.

Many modifications of the embodiments shown in FIG 1 through 8 are possible within the scope of the invention. For instance, the carrier holder 5 and/or the top cover 6 could basically also be mounted at the mounted or the boundaries of the substrate 12 itself rather than on the substrate carrier body 17. Furthermore, instead of or in addition to the photodiode 22 a different photo detector or a photoelectric transducer converting electrical signals into light or optical signals could be provided, for instance a laser or laser diode or LED, and could be arranged at the signal processing device in a similar manner as the photodiode 22. This embodiment could, for example, be used in a bi-directional CATV system.

### LIST OF REFERENCE SYMBOLS

- 3: transducer carrier
- 5: carrier holder
- 5A,5B: pin
- 6: top cover
- 6A to D: pin
- 10: amplifier
- 11: substrate
- 11A, 11B: contact
- 11C to K: contact
- 12: signal processing circuits
- 13, 14: screw hole
- 15A, 15B: connection hole
- 16A to D: connection hole
- 17: substrate carrier body
- 20: photoelectric transducer
- 21:
- 22: photo diode
- 22A, 22B: contact
- 24: ferrule
- 26: glass fiber
- 30: front area
- 31: rear area
- 32: bottom section
- 33: side section
- 34: snapping element
- 35: opening
- 36: glue hole
- 37: edge
- 50: side wall
- 51: opening
- 53: snapping element
- 54: transducer platform
- 55: bar
- 56, 57: adjusting aid
- 58: base
- 61: opening
- 67: opening
- 70: bearing
- 71,72: bearing part

## Claims

1. Optoelectric device comprising
a) at least one photoelectric transducer (20) for converting optical signals into electrical signals and/or electrical signals into optical signals, wherein the photoelectric transducer is connected with a light guide (26) for transmitting optical signals to be converted or converted by the photoelectric transducer,
b) an electric signal processing device (10) and
c) at least one device for arranging the at least one photoelectric transducer (20) at the electric signal processing device (10), comprising
c1) a transducer carrier (3) into or onto which the photoelectric transducer (20) is mounted, and
c2) a carrier holder (5) into or onto which the transducer carrier is mounted,
c3) wherein said carrier holder is mounted onto the electrical signal processing device (10) and
c4) wherein the carrier holder is detachably secured to the signal processing device and/or the transducer carrier is detachably secured to the carrier holder,
d) wherein the light guide (26) the photoelectric transducer is optically connected with is guided or guidable through at least one passage or opening (51, 61) in the transducer carrier and/or the carrier holder.

2. Optoelectric device according to claim 1, wherein the electrical signal processing device comprises at least one substrate carrying electronic components for signal processing and a substrate carrier body onto which the substrate is mounted.

3. Optoelectric device comprising
a) at least one photoelectric transducer (20) for converting optical signals into electrical signals and/or electrical signals into optical signals, wherein the photoelectric transducer is connected with a light guide (26) for transmitting optical signals to be converted or converted by the photoelectric transducer,
b) an electric signal processing device (10) and
c) at least one device for arranging the at least one photoelectric transducer (20) at the electric signal processing device (10), comprising
c1) a transducer carrier (3) into or onto which the photoelectric transducer (20) is mounted, and
c2) a carrier holder (5) into or onto which the transducer carrier is mounted,
c3) wherein said carrier holder is mounted onto the electrical signal processing device (10) and
c4) wherein the carrier holder is detachably secured to the signal processing device and/or the transducer carrier is detachably secured to the carrier holder,
c5) further comprising a top cover, mounted or mountable onto or over the carrier holder and/or onto a substrate comprised by the signal processing device and carrying electronic components for signal processing or onto a substrate carrier body onto which the substrate is mounted,
c6) the top cover and the carrier holder together forming a housing for the transducer carrier with the mounted transducer and preferably also for at least a part of the substrate,
d) wherein the light guide (26) the photoelectric transducer is optically connected with is guided or guidable through at least one passage or opening (51, 61) in the transducer carrier and/or the carrier holder and/or the top cover.

4. Optoelectric device as claimed in claim 2 or 3, wherein the substrate carrier body serves as a heat sink for the substrate and/or is designed according to the internationals standard 50T115.

5. Optoelectric device as claimed in claim 3 or claim 4, wherein the top cover is connected or connectable with or to the substrate carrier or the substrate, in particular by means of at least one pin-hole-connection (6A to 6D, 16A to 16D) and wherein the top cover preferably fixes the carrier holder with respect to the substrate carrier or the substrate.

6. Optoelectric device as claimed in one of claims 3 to 5, wherein the top cover and the carrier holder comprise two corresponding cut-out sections (51, 61) together forming, when mounted, an opening for the light guide.

7. Optoelectric device as claimed in one of claims 1 to 6, wherein the carrier holder is securable or secured to the signal processing device and/or the transducer carrier is securable or secured to the carrier holder by snapping and/or clipping connection means and/or at least one pin-hole-connection.

8. Optoelectric device as claimed in one of claims 1 to 7, wherein the transducer is detachably secured or detachably securable to the transducer carrier, in particular by snapping or clipping means.

9. Optoelectric device as claimed in one of claims 1 to 8, wherein the transducer carrier comprises several holding sections (32, 33, 34) in between of which the transducer is placed and by which the transducer is substantially prevented from moving or falling out.

10. Optoelectric device according to claim 2 or claim 3 or one of claims 4 to 9 referring back to claim 2 or 3, wherein the carrier holder extends over and spaced apart from the substrate and/or the photoelectric transducer is arranged above the substrate at a predetermined distance from the substrate.

11. Optoelectric device according to one of the preceding claims, wherein the carrier holder has a transducer platform for mounting the transducer carrier and a side wall surrounding the transducer platform and preferably also the substrate when the carrier holder is mounted.

12. Optoelectric device as claimed in one of the preceding claims, wherein for self-alignment of at least one pair of the components to be connected the components are provided with adjusting aids (e. g. 56 and 61, 57 and 67) and/or with self-aligning connection means (e. g. 6C and 16C).

13. Optoelectric device as claimed in one of the preceding claims, wherein within at least one passage or opening (51, 61) for the light guide (26) an elastic bearing (70) for the light guide is arranged, preferably providing a center of rotation for the light guide.

14. Optoelectric device according to any of the preceding claims, wherein the light guide is fixed to the transducer carrier and preferably also to the carrier holder, in particular by glue.

15. Optoelectric device according to any of the preceding claims, wherein the photoelectric transducer is electrically connected or connectable to the electrical signal processing device, in particular the substrate with the electronic components, preferably by a soldered connection.

16. Optoelectric device as claimed in one of the preceding claims, wherein the electrical signal processing device comprises an electrical amplifier (10), in particular a cable television or CATV amplifier.

## Patentansprüche

1. Optoelektrische Vorrichtung, umfassend:
a) mindestens einen photoelektrischen Wandler (20) zum Umwandeln optischer Signale in elektrische Signale und/oder elektrischer Signale in optische Signale, wobei der photoelektrische Wandler mit einem Lichtwellenleiter (26) zum Übertragen umzuwandelnder oder mittels des photoelektrischen Wandlers umgewandelter optischer Signale verbunden ist,
b) eine elektrische Signalverarbeitungseinrichtung (10), und
c) mindestens eine Vorrichtung zum Anordnen des mindestens einen photoelektrischen Wandlers (20) an der elektrischen Signalverarbeitungseinrichtung (10), welche Folgendes umfasst:
c1) einen Wandlerträger (3), in oder auf welchem der photoelektrische Wandler (20) montiert ist, und
c2) eine Trägerhalterung (5), in oder auf welcher der Wandlerträger montiert ist,
c3) wobei die Trägerhalterung auf der elektrischen Signalverarbeitungseinrichtung (10) montiert ist, und
c4) wobei die Trägerhalterung lösbar an der Signalverarbeitungseinrichtung befestigt ist und/oder der Wandlerträger lösbar an der Trägerhalterung befestigt ist,
d) wobei der Lichtwellenleiter (26), mit dem der photoelektrische Wandler optisch verbunden ist, durch mindestens eine Durchführung bzw. Öffnung (51, 61) in dem Wandlerträger und/oder der Trägerhalterung geführt bzw. führbar ist.

2. Optoelektrische Vorrichtung nach Anspruch 1, bei welcher die elektrische Signalverarbeitungseinrichtung mindestens ein Substrat, welches elektronische Bauelemente zur Signalverarbeitung trägt, und einen Substratträgerkörper aufweist, auf dem das Substrat montiert ist.

3. Optoelektrische Vorrichtung, umfassend:
a) mindestens einen photoelektrischen Wandler (20) zum Umwandeln optischer Signale in elektrische Signale und/oder elektrischer Signale in optische Signale, wobei der photoelektrische Wandler mit einem Lichtwellenleiter (26) zum Übertragen umzuwandelnder oder mittels des photoelektrischen Wandlers umgewandelter optischer Signale verbunden ist,
b) eine elektrische Signalverarbeitungseinrichtung (10), und
c) mindestens eine Vorrichtung zum Anordnen des mindestens einen photoelektrischen Wandlers (20) an der elektrischen Signalverarbeitungseinrichtung (10), welche Folgendes umfasst:
c1) einen Wandlerträger (3), in oder auf welchem der photoelektrische Wandler (20) montiert ist, und
c2) eine Trägerhalterung (5), in oder auf welcher der Wandlerträger montiert ist,
c3) wobei die Trägerhalterung auf der elektrischen Signalverarbeitungseinrichtung (10) montiert ist, und
c4) wobei die Trägerhalterung lösbar an der Signalverarbeitungseinrichtung befestigt ist und/oder der Wandlerträger lösbar an der Trägerhalterung befestigt ist,
c5) des Weiteren eine obere Abdeckung, welche auf oder über der Trägerhalterung und/oder auf einem Substrat, welches von der Signalverarbeitungseinrichtung umfasst ist und welches elektronische Bauelemente zur Signalverarbeitung trägt, oder auf einem Substratträgerkörper, auf welchem das Substrat montiert ist, montiert bzw. montierbar ist,
c6) wobei die obere Abdeckung und die Trägerhalterung zusammen ein Gehäuse für den Wandlerträger mit dem montierten Wandler und vorzugsweise auch für wenigstens einen Teil des Substrats bilden,
d) wobei der Lichtwellenleiter (26), mit dem der photoelektrische Wandler optisch verbunden ist, durch mindestens eine Durchführung bzw. Öffnung (51, 61) in dem Wandlerträger und/oder der Trägerhalterung und/oder der oberen Abdeckung geführt bzw. führbar ist.

4. Optoelektrische Vorrichtung nach Anspruch 2 oder 3, bei welcher der Substratträgerkörper als Wärmesenke für das Substrat dient und/oder entsprechend der internationalen Norm SOT 115 ausgelegt ist.

5. Optoelektrische Vorrichtung nach Anspruch 3 oder Anspruch 4, bei welcher die obere Abdeckung mit dem Substratträger bzw. dem Substrat verbunden bzw. verbindbar ist, insbesondere mit Hilfe von mindestens einer Stiftloch-Verbindung (6A bis 6D, 16A bis 16D) und bei welcher die obere Abdeckung vorzugsweise die Trägerhalterung bezüglich des Substratträgers bzw. des Substrats fixiert.

6. Optoelektrische Vorrichtung nach einem der Ansprüche 3 bis 5, bei welcher die obere Abdeckung und die Trägerhalterung zwei entsprechende ausgeschnittene Abschnitte (51, 61) aufweisen, welche im montierten Zustand zusammen eine Öffnung für den Lichtwellenleiter bilden.

7. Optoelektrische Vorrichtung nach einem der Ansprüche 1 bis 6, bei welcher mittels einer Schnapp- und/oder Klammer-Verbindungseinrichtung und/oder mindestens einer Stiftloch-Verbindung die Trägerhalterung an der Signalverarbeitungseinrichtung befestigbar bzw. befestigt ist und/oder der Wandlerträger an der Trägerhalterung befestigbar bzw. befestigt ist.

8. Optoelektrische Vorrichtung nach einem der Ansprüche 1 bis 7, bei welcher der Wandler lösbar an dem Wandlerträger insbesondere durch eine Schnapp- oder Klammer-Einrichtung lösbar befestigt oder lösbar befestigbar ist.

9. Optoelektrische Vorrichtung nach einem der Ansprüche 1 bis 8, bei welcher der Wandlerträger mehrere Halteabschnitte (32, 33, 34) aufweist, zwischen denen der Wandler platziert ist und mit deren Hilfe im Wesentlichen eine Bewegung bzw. ein Herausfallen des Wandlers verhindert wird.

10. Optoelektrische Vorrichtung nach Anspruch 2 oder Anspruch 3 oder einem der Ansprüche 4 bis 9, die sich auf Anspruch 2 oder 3 beziehen, bei welcher die Trägerhalterung sich über dem Substrat erstreckt und von diesem beabstandet ist, und/oder bei dem der photoelektrischen Wandler über dem Substrat in einem vorgegebenen Abstand von diesem angeordnet ist.

11. Optoelektrische Vorrichtung nach einem der vorhergehenden Ansprüche, bei welcher die Trägerhalterung eine Wandlerplattform zur Montage des Wandlerträgers und eine Seitenwandung besitzt, welche die Wandlerplattform und vorzugsweise auch das Substrat umgibt, wenn die Trägerhalterung montiert ist.

12. Optoelektrische Vorrichtung nach einem der vorhergehenden Ansprüche, bei welcher zur Selbstausrichtung von mindestens einem Paar der zu verbindenden Bauelemente die Bauelemente mit Einstellhilfen (z.B. 56 und 61, 57 und 67) und/oder mit sich selbst ausrichtenden Verbindungsmitteln (z.B. 6C und 16C) versehen sind.

13. Optoelektrische Vorrichtung nach einem der vorhergehenden Ansprüche, bei welcher im Inneren von mindestens einer Durchführung bzw. Öffnung (51, 61) für den Lichtwellenleiter (26) eine elastische Lagerung (70) für den Lichtwellenleiter angeordnet ist, welche vorzugsweise einen Drehmittelpunkt für den Lichtwellenleiter bildet.

14. Optoelektrische Vorrichtung nach einem der vorhergehenden Ansprüche, bei welcher der Lichtwellenleiter an dem Wandlerträger und vorzugsweise auch an der Trägerhalterung, insbesondere mit Klebstoff, befestigt ist.

15. Optoelektrische Vorrichtung nach einem der vorhergehenden Ansprüche, bei welcher der photoelektrische Wandler mit der elektrischen Signalverarbeitungseinrichtung, insbesondere mit dem Substrat mit den elektronischen Bauelementen, elektrisch verbunden oder verbindbar ist, vorzugsweise mit Hilfe einer Lötverbindung.

16. Optoelektrische Vorrichtung nach einem der vorhergehenden Ansprüche, bei welcher die elektrische Signalverarbeitungseinrichtung einen elektrischen Verstärker (10), insbesondere einen Verstärker für Kabelfernsehen bzw. CATV-Verstärker aufweist.

## Revendications

1. Dispositif optoélectrique comprenant
a) au moins un transducteur photoélectrique (20) pour convertir des signaux optiques en signaux électriques et/ou des signaux électriques en signaux optiques, où le transducteur photoélectrique est connecté à un guide de lumière (26) pour transmettre des signaux optiques à convertir ou convertis par le transducteur photoélectrique,
b) un dispositif de traitement de signaux électriques (10) et
c) au moins un dispositif pour arranger le au moins un transducteur photoélectrique (20) au dispositif de traitement de signaux électriques (10), comprenant
c1) un support de transducteur (3) dans ou sur lequel est monté le transducteur photoélectrique (20), et
c2) un porte support (5) sur lequel ou dans lequel est monté le support de transducteur,
c3) où ledit porte-support est monté sur le dispositif de traitement de signaux électriques (10) et
c4) où le porte-support est fixé détachable au dispositif de traitement de signaux et/ou le support du transducteur est fixé détachable au porte-support,
d) où le guide de lumière (26) le transducteur photoélectrique est optiquement connecté qui est guidé ou guidable par au moins un passage ou ouverture (51,61) dans le support de transducteur et/ou le porte-support.

2. Dispositif optoélectrique selon la revendication 1, où le dispositif de traitement de signaux électriques comprend au moins un substrat portant des composants électroniques pour le traitement des signaux et un corps de support de substrat sur lequel est monté le substrat.

3. Dispositif optoélectrique comprenant :
a) au moins un transducteur photoélectrique (20) pour convertir des signaux optiques en signaux électriques et/ou des signaux électriques en signaux optiques, où le transducteur photoélectrique est connecté à un guide de lumière (26) pour transmettre des signaux optiques à convertir ou convertis par le transducteur photoélectrique,
b) un dispositif de traitement de signaux électriques (10) et
c) au moins un dispositif pour arranger le au moins un transducteur photoélectrique (20) au dispositif de traitement de signaux électriques (10), comprenant
c1) un support de transducteur (3) dans ou sur lequel est monté le transducteur photoélectrique (20), et
c2) un porte support (5) sur lequel ou dans lequel est monté le support de transducteur,
c3) où ledit porte-support est monté sur le dispositif de traitement de signaux électriques (10) et
c4) où le porte-support est fixé détachable au dispositif de traitement de signaux et/ou le support du transducteur est fixé détachable au porte-support,
c5) comprenant de plus un couvercle supérieur, monté ou montable sur ou par-dessus le porte-support et/ou sur un substrat composé par le dispositif de traitement de signaux et portant des composants électroniques pour le traitement des signaux ou sur un corps de support de substrat sur lequel est monté le substrat,
c6) le couvercle supérieur et le porte-support formant ensemble un logement pour le support de transducteur avec le transducteur monté et de préférence, également, pour au moins une partie du substrat, et
d) où le guide de lumière (26) le transducteur photoélectrique est optiquement connecté à et est également de préférence guidé ou guidable par au moins un passage ou ouverture (51,61) dans le couvercle supérieur.

4. Dispositif optoélectrique selon la revendication 2 ou 3, où le corps du support du substrat sert de radiateur de chaleur pour le substrat et/ou est conçu selon la norme internationale 50T115.

5. Dispositif optoélectrique selon la revendication 3 ou la revendication 4, où le couvercle supérieur est connecté ou connectable avec ou au support de substrat ou au substrat, en particulier au moyen d'au moins une connexion à broche et trou (6A à 6D, 16A à 16D) et où le couvercle supérieur fixe de préférence le porte-support par rapport au support du substrat ou au substrat.

6. Dispositif optoélectrique selon l'une quelconque des revendications 3 à 5, où le couvercle supérieur et le porte-support comprennent deux sections en découpe correspondantes (51,61) formant ensemble, lors du montage, une ouverture pour le guide de lumière.

7. Dispositif optoélectrique selon l'une quelconque des revendications 1 à 6, où le porte-support peut être fixé ou est fixé au dispositif de traitement de signaux et/ou le support du transducteur peut être fixé ou est fixé au porte-support en fermant automatiquement et/ou agrafant un moyen de connexion et/ou une connexion à broche et trou.

8. Dispositif optoélectrique selon l'une quelconque des revendications 1 à 7, où le transducteur est fixé détachable ou peut être fixé détachable au support de transducteur, en particulier par fixation automatique ou par un moyen d'agrafage.

9. Dispositif optoélectrique selon l'une quelconque des revendications 1 à 8, où le support de transducteur comprend plusieurs sections de maintien (32,33,34) entre lesquelles est placé le transducteur et par lesquelles le transducteur est sensiblement empêché de se déplacer ou de tomber.

10. Dispositif optoélectrique selon la revendication 2 ou la revendication 3 ou l'une des revendications 4 à 9 en se référant de nouveau à la revendication 2 ou 3, où le porte-support s'étend sur et est espacé du substrat et/ou le transducteur photoélectrique est agencé au-dessus du substrat à une distance prédéterminée à partir du substrat.

11. Dispositif optoélectrique selon l'une quelconque des revendications précédentes, où le porte-support a une plate-forme de transducteur pour montage du support de transducteur et une paroi latérale entourant la plate-forme du transducteur et de préférence, également, le substrat quand le porte-support est monté.

12. Dispositif optoélectrique selon l'une quelconque des revendications précédentes, où, pour l'auto-alignement d'au moins une paire des composants à connecter, les composants sont pourvus d'auxiliaires d'ajustement (e.g. 56 et 61, 57 et 67) et/ou de moyens de connexion à auto-alignement (e.g. 6C et 16C).

13. Dispositif optoélectrique selon l'une quelconque des revendications précédentes, où dans au moins un passage ou ouverture (51,61) pour le guide de lumière (26) est agencé un palier élastique (70) pour le guide de lumière, formant de préférence un centre de rotation pour le guide de lumière.

14. Dispositif optoélectrique selon l'une quelconque des revendications précédentes, où le guide de lumière est fixé au support du transducteur et de préférence, également, au porte-support, en particulier par de la colle.

15. Dispositif optoélectrique selon l'une quelconque des revendications précédentes, où le transducteur photoélectrique est électriquement connecté ou connectable au dispositif de traitement de signaux électriques, en particulier le substrat avec les composants électroniques, de préférence par une connexion soudée.

16. Dispositif optoélectrique selon l'une quelconque des revendications précédentes, où le dispositif de traitement de signaux électriques comprend un amplificateur électrique (10), en particulier, un amplificateur pour télévision par câble ou CATV.
